# EUROPÄISCHE PATENTSCHRIFT

(11) **EP 1 535 730 B1**
(45) Veröffentlichungstag und Bekanntmachung des Hinweises auf die Patenterteilung: **17.03.2010**
(21) Anmeldenummer: 04023558.2
(22) Anmeldetag: 04.10.2004
(51) Int. Cl.: B32B 15/01

(54) **Schichtenfolge zur Herstellung eines Verbundmaterials für elektromechanische Bauelemente**
Layered arrangement and composite material for electromechanical articles
Series de couches et matériau composite pour pièces électromécanique

(30) Priorität: 28.11.2003 DE 10355724
(43) Veröffentlichungstag der Anmeldung: 01.06.2005
(73) Patentinhaber: Wieland-Werke AG, 89070 Ulm (DE)
(72) Erfinder: Buresch, Isabell, Dr., 89257 Illertissen (DE)

(56) Entgegenhaltungen:
- DE-C1- 3 712 691
- US-A- 5 916 695
- US-A- 6 083 633
- US-A1- 2003 035 977
- US-A1- 2003 091 855
- PATENT ABSTRACTS OF JAPAN Bd. 013, Nr. 265 (M-839), 19. Juni 1989 (1989-06-19) & JP 01 064840 A (TAIHO KOGYO CO LTD; others: 01), 10. März 1989 (1989-03-10)
- PATENT ABSTRACTS OF JAPAN Bd. 1999, Nr. 01, 29. Januar 1999 (1999-01-29) & JP 10 284667 A (FURUKAWA ELECTRIC CO LTD:THE; FURUKAWA SEIMITSU KINZOKU KOGYO KK), 23. Oktober 1998 (1998-10-23)

## Beschreibung

Die Erfindung betrifft eine Schichtenfolge auf einem Substrat aus Kupfer oder einer Kupferbasislegierung, aus Nickel oder einer Nickelbasislegierung oder eines verkupferten Substrates zur Herstellung eines Verbundmaterials sowie ein Verfahren zur Herstellung eines Verbundmaterials aus der Schichtenfolge.

Bei Langzeitauslagerung feuerverzinnter und galvanisch verzinnter Cu-und Ni-Basismaterialien sowie verkupferter Substrate entstehen, bedingt durch Diffusionsprozesse, intermetallische Phasen (IMP) wie Cu₃Sn, Cu₆Sn₅ oder Ni₃Sn.

Je nach Schichtdicke der Verzinnung und der Prozessfolge in ihrem Zeit-/Temperaturverlauf bei der Auslagerung können, in Abhängigkeit von der Legierungszusammensetzung, Poren an der Grenzfläche Grundmaterial/Beschichtung auftreten. Im ungünstigsten Fall kann es zur Abplatzung der Sn-Schicht kommen. Insbesondere bei einem Einsatz bei elektromechanischen Bauelementen kann ein Abplatzen der Sn-Schicht vom Grundmaterial zu einem Totalausfall des Bauteils führen.

Diese Porenbildung aufgrund von Diffusionsvorgängen im Festkörper ist als Kirkendall Effekt bekannt und beruht auf der unterschiedlichen Diffusionsgeschwindigkeit von Sn und Cu und seiner Legierungselemente. Dabei können die im Grundmaterial enthaltenen Legierungselemente diesen Effekt beschleunigen oder aber bremsen.

Es besteht prinzipiell die Möglichkeit, vor dem Aufbringen der Sn-Schicht eine die Diffusion hemmende Zwischenschicht direkt auf das Grundmaterial abzuscheiden. Diese Sperrschicht soll verhindern, dass Legierungselemente aus dem Grundmaterial in die Sn-Schicht diffundieren. Das problematische Wachstum der CuSn- bzw. NiSn-IMP wird dadurch verhindert oder zumindest gebremst. Wichtige, beispielsweise für eine gute Lötbarkeit verantwortliche Schichteigenschaften bleiben erhalten, andere, wie beispielsweise eine gute Biegbarkeit können je nach gewählter Sperrschicht und Dicke verschlechtert werden.

Auch wenn durch die Verwendung von herkömmlichen Sperrschichten gewisse Schichteigenschaften gewährleistet werden, verbleibt das grundlegende Problem einer Porenbildung durch Diffusion bei Langzeittemperaturauslagerung (z. B. 150°C/3000 h). Die Gefahr des Abplatzens der Beschichtung vom Grundmaterial kann jedoch nicht durch diese üblichen Zwischenschichten bei Cu-Legierungen verhindert werden.

In einer Publikation von Scott, B.C. und Warwick, M. E. (Intern. Tin Res. Inst., Transact. of the Inst. of Met. Finishing, (1982), Vol. 61, pp. 44ff.) ist die Wirkung einer Fe-Sperrschicht im Vergleich zu einer Cu-Sperrschicht im Hinblick auf die Wachstumsgeschwindigkeit der Cu-Sn-IMP beschrieben.

Die verwendete Eisen-Sperrschicht bildet bei Temperaturen von 170°C eine FeSn₂-IMP. Das Dickenwachstum ist allerdings entsprechend gering, wodurch eine wirksame Sperre gegen die Diffusion von Sn nur gegeben ist, solange diese frei von Poren ist. Sobald Poren in der Fe-Schicht vorhanden sind, bildet sich unter der Fe-Schicht eine Cu₆Sn₅-IMP, welche dazu führt, dass die Fe-Sperrschicht vom Grundmaterial abplatzt. Porendichte Schichten können erst ab ungefähr 2 µm Schichtdicke erreicht werden. Da insbesondere verhältnismäßig dicke Fe-Schichten aufgrund der magnetischen Eigenschaften in der Elektronikindustrie Probleme bereiten können, wurde bisher davon in der Praxis Abstand genommen.

Des Weiteren ist aus der Druckschrift US 5,916,695 eine zwischen einem kupferhaltigen Substrat und einer Zinn-Deckschicht angeordnete Ni-haltige Zwischenschicht bekannt, welche die Diffusion von Kupfer aus dem Substrat in die Zinnschicht vermeiden soll. Die Zwischenschicht besteht weitgehend aus Kupfer mit einem Anteil von 20 - 40 Gew.-% Nickel.

Die beschriebene Lösung ist jedoch nur von zeitlich begrenzter Haltbarkeit. Nachdem die Cu/Ni-Schicht durch Bildung einer intermetallischen (Cu-Ni)Sn-Phase aufgezehrt worden ist, setzt der übliche Mechanismus innerhalb der vorgesehenen Funktionsdauer ein. Aufgrund der Kondensation der Leerstellenströme im Material kommt es durch den beschriebenen Kirkendall-Effekt an der Grenzschicht zum Cu-Substrat zu der unerwünschten Bildung von flächigen Ablösungen.

In der Druckschrift US 2003/0091855 A1 wird ein Schichtaufbau aus zwei Zwischenschichten und einer Deckschicht beschrieben, mit dem Ziel, die vollständige Umwandlung der Sn-Deckschicht in IMP zu verhindern und damit bei hohen Temperaturen eine Rest Sn-Schicht auf der Oberfläche zu garantieren. Die Lösung mit einer Cu-Zwischenschicht als alleinige Reaktionsschicht fördert jedoch gerade bei hohen Temperaturen den Kirkendall-Effekt und führt damit zu einem Abplatzen der Sn-Schicht von der darunter befindlichen Zwischenschicht.

Aus der Druckschrift DE 37 12 691 C1 ist ein elektrischer Anschlussstift als Lötanschluss von elektrischen Leitungen bekannt. Auf ein aus einer Kupfer-ZinnLegierung bestehendes Stiftmaterial wird zunächst eine Nickel-Sperrschicht aufgebracht, über welche eine für den Anschluss der elektrischen Leitung dienende äußere Lötschicht aus einem Blei-Zinn-Gemisch angeordnet wird. Um die Lötfähigkeit zu gewährleisten, wird vorgeschlagen, zwischen der inneren Nickel-Sperrschicht und der äußeren Zinn-Lötschicht eine Silber-Zwischenschicht aufzugalvanisieren und durch Temperung mit der äußeren Zinn-Lötschicht eine Diffusionslegierung zu erzeugen.

Der Erfindung liegt daher die Aufgabe zugrunde, insbesondere für Zinnbeschichtungen, die Haftung der Schicht auch gegenüber Langzeittemperaturauslagerungen nachhaltig zu verbessern und die Schichteigenschaften zu stabilisieren.

Die Erfindung wird bezüglich der Schichtenfolge zur Herstellung eines Verbundmaterials durch die Merkmale des Anspruchs 1, bezüglich des Verfahrens zur Herstellung des Verbundmaterials durch die Merkmale des Anspruchs 8 wiedergegeben. Die weiteren Ansprüche geben vorteilhafte Aus- und Weiterbildungen der Erfindung wieder.

Die Erfindung schließt die technische Lehre bezüglich einer Schichtenfolge auf einem Substrat aus Kupfer oder einer Kupferbasislegierung, aus Nickel oder einer Nickelbasislegierung oder eines verkupferten Substrates zur Herstellung eines Verbundmaterials, wobei eine Deckschicht, bestehend aus Zinn oder einer Legierung auf Zinnbasis, die zumindest über einem Teil des Substrates angeordnet ist, eine Sperrschicht, die zwischen dem Substrat und der Deckschicht liegt und mit dem Substrat unmittelbar in Kontakt steht, wobei die Sperrschicht aus zumindest einem Element der Gruppe Fe, Co, Nb, Mo oder Ta besteht, und eine Zwischenschicht, die zwischen der Sperrschicht und der Deckschicht liegt und mit der Sperrschicht unmittelbar in Kontakt steht, wobei die Zwischenschicht aus zumindest einem Element der Gruppe Cu oder Ni besteht und eine Reaktionsschicht, die zwischen Deckschicht und Zwischenschicht liegt und aus Ag oder einer Ag-Legierung, aus Pt oder Pd oder seinen Legierungen besteht.

Die Erfindung geht dabei von der Überlegung aus, dass zwischen der Deckschicht und dem Substrat weitere Schichten eingebracht werden. Die äußerste Schicht des Schichtverbundes ist reines Sn oder eine Sn-Legierung, die je nach Anwendungszweck gewählt wird. Beispielsweise kann eine Legierung auf Sn-Basis aus 0 - 50 Gew.-% Sn und aus einem oder mehreren der Elemente Ag, Cu, Ni, In, Co, Bi, Pb und Sb zusammengesetzt sein. Darunter befindet sich eine Reaktionsschicht aus Ag, Pd, Pt oder deren Legierungen und darunter die Zwischenschicht aus Cu und Ni und darunter wiederum eine Sperrschicht. Die genannten Elemente der Sperrschicht können auch in Form einer Legierung eingesetzt werden. Auch eine mehrlagige Schichtabfolge, beispielsweise einer Kombination aus Fe und Co oder Ta und Co, ist denkbar. Die Schichten sind auf Kupfer oder einer Cu-Legierung, einem verkupferten Bauteil als Substrat aufgebracht. Die Sperrschicht besteht aus den genannten Reinelementen oder aus einer Mischung derselben.

Die Reaktionsschicht, welche aus Ag, Pd oder Pt bzw. ihren Legierungen besteht, reagiert bei hohen Temperaturen mit der Deckschicht und je nach Dicke auch mit der Zwischenschicht zu einer intermetallischen Phase. Dies ist beispielsweise der Fall, wenn die Reaktionsschicht aus Ag und die Deckschicht aus Sn oder seinen Legierungen besteht. Je nach Dicke der Reaktions- und Deckschicht findet somit eine Veredelung und Härtung der Deckschicht statt, ohne dass die Haftfestigkeit im Gebrauch unter Temperaturbelastung gefährdet ist.

Die Wirkung dieses Schichtverbundes gegen ein Ablösen der Deckschicht (Peeling) beruht darauf, dass an der Grenzfläche der Sn-Legierung zur Reaktionsschicht eine intermetallische Phase gebildet wird, die eine weitere Diffusion der Schichtkomponenten bereits vermindert. Nachdem gegebenenfalls die Reaktionsschicht durch Bildung der intermetallischen Phase aufgezehrt worden ist, kann eine gezielte Reaktion mit der Zwischenschicht je nach Schichtdicke erfolgen. Die Diffusion stoppt an der Sperrschicht. Auf diesen Schichtenkombinationen können problemlos hochglänzende und dauerhaft haftende Verzinnungen als oberste Deckschicht realisiert werden.

An der Grenzschicht zum Substrat oder einer Zwischenschicht kommt es dadurch nicht zu der unerwünschten Bildung von flächigen Ablösungen, die durch eine Kondensation der Lehrstellenströme entstehen können. Durch die erfindungsgemäße Lösung wird dem Mangel abgeholfen, dass in Verbindung mit einer Cu/Ni-Schicht der bisher nicht effektiv genutzte Blockiereffekt einer separaten Sperrschicht zwischen Substrat und Reaktionsschicht ausgenutzt wird. Grundsätzlich wäre auch denkbar, beispielsweise auf eine Sperrschicht aus Tantal direkt eine Sn-Schicht aufzubringen, jedoch ist dies nur bei großer Dicke der Sperrschicht funktionell und erlaubt nur in eingeschränktem Maße die Abscheidung einer hochglänzenden Sn-Schicht. In diesem Fall wäre die Biegbarkeit des Verbundes stark eingeschränkt. Zudem kommt es nicht zu einer Veredelung der Sn-Schicht, beispielsweise durch Ag, und damit zu einer Stabilisierung des Übergangswiderstandes und der Durchriebfestigkeit. Daher wird auch in diesen Fällen zwischen Sperrschicht und Sn-Schicht zumindest eine verhältnismäßig dünne Reaktionsschicht eingebracht.

Das durch die Reaktionsschicht und Zwischenschicht diffundierende Sn wird an der Sperrschicht durch die Reaktion, beispielsweise mit Fe, zu einer weiteren intermetallischen Phase abgebunden, die den weiteren Fortgang der Reaktion stoppt. Hierdurch wird sehr effizient für die Gebrauchsdauer von bis zu 3000 h und Temperaturen bis zu 200°C die Ausbildung von intermetallischen Phasen aus Cu und Sn an der Grenzfläche zum Substrat unterbunden.

Die gewünschte Sperrwirkung wird bereits mit vergleichsweise geringer Schichtdicke erzielt. In bevorzugter Ausgestaltung der Erfindung kann die Sperrschicht eine Dicke von 0,2 - 1,0 µm aufweisen. Schichtdicken in diesem Bereich können entweder so genannte galvanische Flashschichten sein oder auch Schichten, die mittels PVDoder CVD-Verfahren abgeschieden werden.

In bevorzugter Ausführungsform kann die Zwischenschicht entweder aus einer Cu-Ni-Legierung oder einer Schichtenabfolge aus einer Ni- und einer Cu-Schicht bestehen. Vorteilhafterweise weist die Zwischenschicht eine Dicke von 0,2 - 2,0 µm auf. Bei geringeren Schichtdicken besteht die Gefahr, dass Elemente aus der Sperrschicht an die Oberfläche diffundieren und zu unerwünscht schlecht leitenden Korrosionsprodukten führen.

Auf diese Grundbeschichtungen kann dann galvanisch die gewünschte Sn-Schicht abgeschieden werden. In einer Ausführungsform weist die Deckschicht eine größere Dicke als die Reaktionsschicht auf. Da ein Teil der Sn-Schicht durch eine nachfolgende Wärmebehandlung aufgebraucht wird, muss jedenfalls dafür gesorgt werden, dass die verbleibende Dicke der Sn-Deckschicht noch für eine vollständige Bedeckung der Oberfläche ausreicht. Die Reaktionsschicht hat vorteilhafterweise eine Schichtdicke, welche zwischen 1/3 bis 1/1 der Dicke der Deckschicht entspricht, um beispielsweise bei einem Verhältnis von 1:3 zu gewährleisten, dass nach 1000 h bei 200°C noch freies Sn an der Oberfläche verbleibt; bei einem Verhältnis von 1:1 wird die gesamte Sn-Schicht in eine IMP mit der Reaktionsschicht veredelt. Eine optimale Abstimmung des gesamten Schichtverbundes liegt in dem genannten Dickenbereich. Schichtdicken über dem angegebenen Bereich sind nicht erforderlich, um in Verbindung mit einer Sperrschicht die gewünschte Wirkung zu erzielen. Die Ausführung im Schichtdickenverhältnis 1:1 erlaubt die einfache und kostengünstige Herstellung von SnAg- oder SnAgCu-Oberflächen nach einer Reflowbehandlung, welche gute elektrische und mechanische Eigenschaften aufweisen.

Vorteilhafterweise kann jedoch die Reaktionsschicht eine größere Dicke als die Sperrschicht und die Zwischenschicht aufweisen. Um die Sperrwirkung zu erzielen sind bei den ausgewählten Materialien prinzipiell geringere Schichtdicken erforderlich, als bei der aufzubrauchenden Reaktionsschicht. Die Zwischenschicht hemmt mit der Reaktionsschicht die Sn-Diffusion zum Grundmaterial bereits in einem beträchtlichen Maße, so dass ein auf die Sperrschicht treffender Anteil auch bei geringer Sperrschichtdicke bereits ausreicht, die weitere Diffusion von Zinn in das Substrat zu verhindern.

Vorteilhafterweise ist die gesamte Schichtdicke auf dem Substrat geringer als 12 µm, vorzugsweise geringer als 3 µm. Bereits diese Schichtdicken bewirken eine dauerhafte und zuverlässige Sn-Beschichtung eines Substrates aus Kupfer- oder einer Kupferlegierung oder eines verkupferten Substrates. Vorteilhafterweise handelt es sich bei zumindest einer Schicht um eine Galvanikschicht, PVD oder CVD-Schicht.

Nach einem weiteren Aspekt der Erfindung wird ein Verfahren zur Herstellung eines Verbundmaterials aus der erfindungsgemäßen Schichtenfolge durch eine Wärmebehandlung der Schichtenfolge über der Schmelztemperatur der Deckschicht vorgeschlagen (Reflow-Behandlung).

Substrat mit Sperrschicht, Zwischenschicht und Reaktionsschicht und Sn-Schicht können so einer konventionellen Reflow-Behandlung unterzogen werden, um die gegenseitige Diffusionsbindung der Schichten zu erreichen. Während der Behandlung wird die Schichtenfolge des auszubildenden Verbunds ausreichend lange über die Schmelztemperatur der Deckschicht erwärmt und anschließend abgekühlt. Nach einer erfolgreichen Reflow-Behandlung ist zwischen Sn-Schicht und Reaktionsschicht Interdiffusion aufgetreten, die zur Bildung der in gewissem Ausmaß erwünschten AgSn-intermetallischen Phasen geführt hat. Zwischen Zwischenschicht und Reaktionsschicht einerseits und Sperrschicht und Zwischenschicht andererseits ist es ebenfalls zu Interdiffusion gekommen, die die Haftung der Sperrschicht auf dem Substrat und innerhalb des Schichtverbundes verbessert. Ein auf diese Weise hergestelltes Verbundmaterial zeichnet sich nun dadurch aus, dass bei Temperaturen bis zu 200°C nach bis zu 3000 h keinerlei Peeling-Effekte durch Leerstellenkondensation beobachtet werden.

In bevorzugter Ausführung der Erfindung kann die Wärmebehandlung in Öl durchgeführt werden. Insbesondere durch Eintauchen in Parafinöl oder Esteröl kann, durch einen gezielten Wärmetransport mittels Konvektion des flüssigen Mediums, die Reflow-Behandlung gleichmäßig und gezielt gesteuert werden. Zudem können sich im gleichen Prozess Zinnschichten mit selbst schmierenden Eigenschaften einstellen. Das über das erfindungsgemäße Verfahren hergestellte Verbundmaterial eignet sich bevorzugt für elektromechanische Bauelemente, Leadframes und starr und flexiblen Leiterplatten.

Die mit der Erfindung erzielten Vorteile, eine wirksame Sperrschicht für Sn-Schichten nach Langzeittemperaturauslagerungen anzugeben, bestehen insbesondere darin, dass es nicht zu Abplatzungen der Gesamtschicht kommt und zugleich einen wirksamen Schutz gegen Durchrieb bildet. Weitere vorteilhafte Eigenschaften der erfindungsgemäßen Schichten sind ein niedriger Übergangswiderstand, Korrosionsbeständigkeit sowie eine gute Lötbarkeit. Zudem liegt insbesondere nach einer Reflow-Behandlung eine hochglänzende Sn-Schicht vor, die besonders beständig gegen Reibkorrosion ist.

Ausführungsbeispiele der Erfindung werden anhand von schematischen Zeichnungen näher erläutert.

Darin zeigen:
- Fig. 1: eine Schichtenfolge auf einem Substrat, und
- Fig. 2: eine erfindungsgemäße Schichtenfolge mit zweilagiger Reaktionsschicht.

Einander entsprechende Teile sind in allen Figuren mit denselben Bezugszeichen versehen.

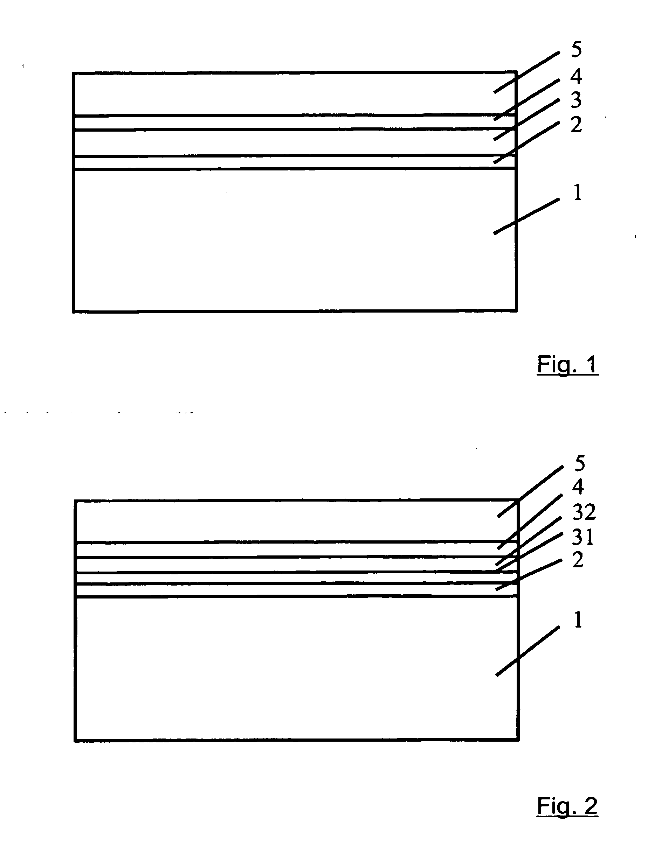

Die Schichtenfolge gemäß Fig. 1 ist auf einem Substrat 1 aus Kupfer oder einer Kupferbasislegierung abgeschieden. Die Deckschicht 5 besteht aus Zinn oder einer Legierung auf Zinnbasis, die die Oberfläche nur zum Teil bedeckt oder, wie in der Figur dargestellt, flächendeckend angeordnet ist. Die Sperrschicht 2 steht mit dem Substrat 1 in unmittelbarem Kontakt. Die Materialien für die Sperrschicht 2 sind aus der Gruppe Fe, Co, Nb, Mo oder Ta. Zwischen der Deckschicht 5 und der Sperrschicht 2 befindet sich die Zwischenschicht 3 und die Reaktionsschicht 4, wobei die Zwischenschicht 3 in dem Beispiel aus einer Cu/Ni-Legierung mit einem Anteil von bis zu 40 Gew.-% Ni besteht. Die Reaktionsschicht weist eine Dicke auf, welche ungefähr 1/3 der Dicke der Deckschicht (5) entspricht.

Fig. 2 zeigt im Wesentlichen dieselbe Schichtenfolge auf dem Substrat 1 mit dem Unterschied, dass die Zwischenschicht 3 zweilagig aus Nickel und Kupfer ausgebildet ist. Bei der besonders bevorzugten Variante befindet sich die Nickelschicht 31 einerseits in direktem Kontakt mit der Sperrschicht 2, die Kupferschicht 32 befindet sich andererseits in Kontakt mit der Reaktionsschicht 4, die aus Ag besteht.

Zur weiter führenden Erläuterung der Erfindung dient das folgende Ausführungsbeispiel.
Ein Band 0,2 x 32 mm aus der Cu-Legierung C7025 (CuNi3Si1Mg) wird mit der erfindungsgemäßen Schichtenfolge beschichtet. Hierzu wird auf das Band mit einer Galvanikanlage ein Fe-Flash von 0,5 µm Dicke aufgebracht. So genannte Flashschichten sind Abscheidungen mit verhältnismäßig geringer Schichtdicke. Darauf wird eine Nickelschicht von 0,6 µm und darauf wiederum ein Cu-Flash von 0,2 µm Dicke abgeschieden. Als Reaktionsschicht dient eine 0,5 µm Ag-Schicht und als letzte Schicht wird eine reine Sn-Schicht von 1,0 µm Dicke abgeschieden und der Schichtverbund einer Reflow-Behandlung unterzogen.

Das erhaltene bandförmige Verbundmaterial wird wiederum bei 125 °C und bei 150 °C gelagert und in gewissen Zeitabständen untersucht.
Dabei stellt man fest, dass im Unterschied zu dem bekannten Verfahren des Standes der Technik bei 150 °C nach 1000 h keine Ablösungen durch Peeling beobachtet werden. Die Auslagerungen wurden bis zu 3000 h fortgesetzt, jedoch keine Anzeichen für Peeling festgestellt.

Es hat sich gezeigt, dass sogar für über 3000 h hinausreichende Zeiträume bei Temperaturen bis zu 170°C durch den erfindungsgemäßen Schichtaufbau die gewünschte Haltbarkeit der Verzinnung erlangt werden kann. Durch die Bildung der SnAg₃-IMP wird zudem der Übergangswiderstand auf einem stabil niedrigen Niveau gehalten.

### Bezugszeichenliste

- 1: Substrat
- 2: Sperrschicht
- 3: Zwischenschicht, Legierung
- 31: Zwischenschicht, erste Schicht
- 32: Zwischenschicht, zweite Schicht
- 4: Reaktionsschicht
- 5: Deckschicht

## Patentansprüche

1. Schichtenfolge auf einem Substrat (1) aus Kupfer oder einer Kupferbasislegierung, aus Nickel oder einer Nickelbasislegierung oder eines verkupferten Substrates zur Herstellung eines Verbundmaterials, **gekennzeichnet durch**:
- eine Deckschicht (5), bestehend aus Zinn oder einer Legierung auf Zinnbasis, die zumindest über einem Teil des Substrates (1) angeordnet ist,
- eine Sperrschicht (2), die zwischen dem Substrat (1) und der Deckschicht (5) liegt und mit dem Substrat (1) unmittelbar in Kontakt steht, wobei die Sperrschicht (2) aus zumindest einem Element der Gruppe Fe, Co, Nb, Mo oder Ta besteht, und
- eine Zwischenschicht (3, 31,32), die zwischen der Sperrschicht (2) und der Deckschicht (5) liegt und mit der Sperrschicht (2) unmittelbar in Kontakt steht, wobei die Zwischenschicht (3, 31, 32) aus zumindest einem Element der Gruppe Cu oder Ni besteht.
- eine Reaktionsschicht (4), die zwischen Deckschicht (5) und Zwischenschicht (3) liegt und aus Ag oder einer Ag-Legierung, aus Pt oder Pd oder seinen Legierungen besteht, wobei die Reaktionsschicht (4) eine Dicke aufweist, welche zwischen 1/3 bis 1/1 der Dicke der Deckschicht (5) entspricht.

2. Schichtenfolge nach Anspruch 1, **dadurch gekennzeichnet, dass** die Sperrschicht (2) eine Dicke von 0,2 - 1,0 µm besitzt.

3. Schichtenfolge nach Anspruch 1 oder 2, **dadurch gekennzeichnet, dass** die Zwischenschicht (3, 31, 32) eine Cu-Ni-Legierung oder eine Schichtenfolge einer Ni- und einer Cu-Schicht ist.

4. Schichtenfolge nach Anspruch 3, **dadurch gekennzeichnet, dass** die Zwischenschicht (3, 31, 32) eine Dicke von 0,2 - 2,0 µm aufweist.

5. Schichtenfolge nach einem der Ansprüche 1 bis 4, **dadurch gekennzeichnet, dass** die Reaktionsschicht (4) eine größere Dicke als die Sperrschicht (2) und die Zwischenschicht (3, 31, 32) aufweist.

6. Schichtenfolge nach einem der Ansprüche 1 bis 5, **dadurch gekennzeichnet, dass** die gesamte Schichtdicke auf dem Substrat (1) geringer als 12 µm, vorzugsweise geringer als 3 µm ist.

7. Schichtenfolge nach einem der vorstehenden Ansprüche, **dadurch gekennzeichnet, dass** es sich bei zumindest einer Schicht um eine Galvanikschicht, einer PVD- oder CVD-Schicht handelt.

8. Verfahren zur Herstellung eines Verbundmaterials aus der Schichtenfolge nach einem der Ansprüche 1 bis 7, **gekennzeichnet durch** eine Wärmebehandlung der Schichtenfolge über der Schmelztemperatur der Deckschicht (5).

9. Verfahren zur Herstellung eines Verbundmaterials aus der Schichtenfolge nach Anspruch 8, **dadurch gekennzeichnet, dass** die Wärmebehandlung in Öl, insbesondere in Parafinöl oder Esteröl, durchgeführt wird.

10. Verwendung des nach dem Verfahren nach Anspruch 8 oder 9 hergestellten Verbundmaterials für elektromechanische Bauelemente, Leadframes und starr und flexiblen Leiterplatten.

## Claims

1. Sequence of layers on a substrate (1) comprising copper or a copper-based alloy, nickel or a nickel-based alloy or a copper-plated substrate for producing a composite material,
**characterised by**:
- a top layer (5), comprising tin or an alloy on the basis of tin which is arranged at least over a portion of the substrate (1),
- a barrier layer (2) which is between the substrate (1) and the top layer (5) and which is directly in contact with the substrate (1), with the barrier layer (2) comprising at least one element from the group Fe, Co, Nb, Mo or Ta, and
- an intermediate layer (3, 31, 32) which is between the barrier layer (2) and the top layer (5) and which is directly in contact with the barrier layer (2), with the intermediate layer (3, 31, 32) comprising at least one element from the group Cu or Ni,
- a reaction layer (4) which is between the top layer (5) and the intermediate layer (3) and which comprises Ag or an Ag alloy, Pt or Pd or alloys thereof, with the reaction layer (4) having a thickness which corresponds to a value between 1/3 to 1/1 of the thickness of the top layer (5).

2. Sequence of layers according to claim 1, **characterised in that** the barrier layer (2) has a thickness of from 0.2 to 1.0 µm.

3. Sequence of layers according to claim 1 or claim 2, **characterised in that** the intermediate layer (3, 31, 32) is a Cu-Ni alloy or a sequence of layers of an Ni layer and a Cu layer.

4. Sequence of layers according to claim 3, **characterised in that** the intermediate layer (3, 31, 32) has a thickness of from 0.2 to 2.0 µm.

5. Sequence of layers according to any one of claims 1 to 4, **characterised in that** the reaction layer (4) has a greater thickness than the barrier layer (2) and the intermediate layer (3, 31, 32).

6. Sequence of layers according to any one of claims 1 to 5, **characterised in that** the total layer thickness on the substrate (1) is less than 12 µm, preferably less than 3 µm.

7. Sequence of layers according to any one of the preceding claims, **characterised in that** at least one layer is a galvanic layer, a PVD layer or CVD layer.

8. Method for producing a composite material from the sequence of layers according to any one of claims 1 to 7, **characterised by** thermal processing of the sequence of layers above the melting temperature of the top layer (5).

9. Method for producing a composite material from the sequence of layers according to claim 8, **characterised in that** the thermal processing is carried out in oil, in particular in paraffin oil or ester oil.

10. Use of the composite material produced in accordance with the method according to claim 8 or claim 9 for electromechanical structural elements, lead frames and rigid and flexible printed-circuit boards.

## Revendications

1. Série de couches successives sur un substrat (1) en cuivre ou en un alliage à base de cuivre, en nickel ou en un alliage à base de nickel ou sur un substrat cuivré, pour la fabrication d'un matériau composite,
**caractérisée par**
- une couche de couverture (5) constituée d'étain ou un alliage à base d'étain, qui est agencée par-dessus au moins une partie du substrat (1),
- une couche formant barrière (2), qui se situe entre le substrat (1) et la couche de couverture (5) et est en contact direct avec le substrat (1), la couche formant barrière (2) étant constituée d'au moins un élément du groupe Fe, Co, Nb, Mo ou Ta, et
- une couche intermédiaire (3, 31, 32), qui se situe entre la couche formant barrière (2) et la couche de couverture (5) et est en contact direct avec la couche formant barrière (2), la couche intermédiaire (3, 31, 32) étant constituée d'au moins un élément du groupe Cu ou Ni,
- une couche de réaction (4), qui se situe entre la couche de couverture (5) et la couche intermédiaire (3) et est constituée d'Ag ou d'un alliage d'Ag, de Pt ou Pd ou ses alliages, la couche de réaction (4) présentant une épaisseur qui correspond à 1/3 à 1/1 de l'épaisseur de la couche de couverture (5).

2. Série de couches successives selon la revendication 1, **caractérisée en ce que** la couche formant barrière (2) possède une épaisseur de 0,2 - 1,0 µm.

3. Série de couches successives selon la revendication 1 ou la revendication 2, **caractérisée en ce que** la couche intermédiaire (3, 31, 32) est un alliage de Cu-Ni ou une succession de couches d'une couche de Ni et d'une couche de Cu.

4. Série de couches successives selon la revendication 3, **caractérisée en ce que** la couche intermédiaire (3, 31, 32) présente une épaisseur de 0,2 - 2,0 µm.

5. Série de couches successives selon l'une des revendications 1 à 4, **caractérisée en ce que** la couche de réaction (4) présente une épaisseur plus grande que la couche formant barrière (2) et la couche intermédiaire (3, 31, 32).

6. Série de couches successives selon l'une des revendications 1 à 5, **caractérisée en ce que** l'épaisseur totale de couche sur le substrat (1) est inférieure à 12 µm, de préférence inférieure à 3 µm.

7. Série de couches successives selon l'une des revendications précédentes, **caractérisée en ce que** qu'il s'agit pour au moins une couche, d'une couche de dépôt par électrolyse, d'une couche obtenue par dépôt PVD (dépôt physique en phase vapeur) ou CVD (dépôt chimique en phase vapeur).

8. Procédé de fabrication d'un matériau composite à partir de la série de couches successives selon l'une des revendications 1 à 7, **caractérisé par** un traitement thermique de la série de couches successives au-dessus de la température de fusion de la couche de couverture (5).

9. Procédé de fabrication d'un matériau composite à partir de la série de couches successives, selon la revendication 8, **caractérisé en ce que** le traitement thermique est effectué dans de l'huile, notamment dans de l'huile de paraffine ou de l'huile-ester.

10. Utilisation du matériau composite fabriqué d'après le procédé selon la revendication 8 ou la revendication 9, pour des éléments de construction électromécaniques, des "leadframes" (supports de connexion) et des plaquettes ou cartes de circuits rigides et flexibles.
